# EUROPÄISCHE PATENTANMELDUNG

(11) **EP 2 100 686 A1**
(43) Veröffentlichungstag der Anmeldung: **16.09.2009**
(21) Anmeldenummer: 08004447.2
(22) Anmeldetag: 11.03.2008
(51) Int. Cl.: B23K 1/005, B23K 3/08

(54) **Verfahren zum Verlöten von metallischen Fügepartnern sowie Vorrichtung dafür**

(71) Anmelder: ProLas GmbH, 52146 Würselen (DE)
(72) Erfinder: Hänsch, Dirk, Dr., 4730 Hauset (BE); Deschler, Marc, Dr., 52072 Aachen (DE)
(74) Vertreter: Paul, Dieter-Alfred

(57) **Zusammenfassung**

Verfahren zum Verlöten von metallischen Fügepartnern (4, 5), die mit Lötmaterial beschichtet sind, bei dem die Lötmaterialschichten der Fügepartner (4, 5) in einem Lötbereich (6) zusammengepresst und aufgeschmolzen werden, wobei sich Schmelzen aus flüssigem Lötmaterial bilden, die nach ihrer Vermischung im erstarrten Zustand die Fügepartner (4, 5) im Lötbereich (6) verbinden, wobei auf die Schmelzen aus flüssigem Lötmaterial vor dem Erstarren ein mechanischer Impuls übertragen wird.

## Beschreibung

Die Erfindung betrifft ein Verfahren zum Verlöten von metallischen Fügepartnern, die mit Lötmaterial beschichtet sind, bei dem die Lötmaterialschichten der Fügepartner in einem Lötbereich zusammengepresst und aufgeschmolzen werden, wobei sich Schmelzen aus flüssigem Lötmaterial bilden, die nach ihrer Vermischung im erstarrten Zustand die Fügepartner im Lötbereich verbinden. Ein weiterer Aspekt der Erfindung betrifft eine Vorrichtung zur Durchführung des Verfahrens.

Im Stand der Technik sind Verfahren zum Verlöten von metallischen Fügepartnern, die mit Lötmaterial beschichtet sind, bekannt. Fügepartner können beispielsweise Metallbleche sein, die mit einer Beschichtung aus einem Lötmaterial versehen sind. Diese werden bei den bekannten Verfahren mit ihren jeweiligen Lötmaterialbeschichtungen in Anlage gebracht und zusammengepresst. Anschließend wird das Lötmaterial auf den Fügepartnern aufgeschmolzen, indem die notwendige Energie beispielsweise mit Hilfe eines Laserstrahls zugeführt wird. Dabei bildet sich auf beiden Metallblechen Schmelzen aus flüssigem Lötmaterial, die sich miteinander zu einer Schmelze vereinigen. Nach dem Abkühlen bildet die erstarrte vereinigte Schmelze eine Lötstelle, die die Fügepartner im Lötbereich verbindet.

Bei dem bekannten Verfahren ist es notwendig Flussmittel zu verwenden, um eine homogene Vermischung der Schmelzen aus flüssigem Lötmaterial und z.B. eine gute Benetzung der Blechoberflächen zu gewährleisten. Allerdings gelingt es auch bei der Verwendung von Flussmitteln nicht immer, eine ausreichende Benetzung der zu verlötenden Metallbleche sicherzustellen, so dass die hergestellten Lötverbindungen keine ausreichende mechanische Belastbarkeit aufweisen.

Es ist daher Aufgabe der vorliegenden Erfindung ein Verfahren der eingangs genannten Art anzugeben, bei dem ohne Zusatz von Flussmitteln Lötverbindungen mit besonders hoher mechanische Belastbarkeit hergestellt werden können.

Diese Aufgabe wird erfindungsgemäß dadurch gelöst, dass auf die Schmelzen aus flüssigem Lötmaterial vor dem Erstarren ein mechanischer Impuls übertragen wird.

Grundgedanke der Erfindung ist es, das Lötmaterial auf den Fügepartnern ohne Zusatz von Flussmittel aufzuschmelzen und dann auf die Schmelzen aus flüssigem Lötmaterial einen mechanischen Impuls zu übertragen. Hierdurch wird die Vereinigung der Schmelzen zu einer einheitlichen Schmelze unterstützt. So kommt es in Folge der Impulsübertragung zu einer intensiven Vermengung der Schmelzen, wobei gleichzeitig eventuell an der Oberfläche der einzelnen Schmelzen vorhandene Oxidschichten und Verunreinigungen, die eine Vereinigung der Schmelzen verhindern können, zerstört werden. Darüber hinaus trägt die Übertragung des mechanischen Impulses dazu bei, dass die Oberflächen der zu verbindenden Fügepartnern besonders gut mit dem flüssigen Lötmaterial benetzt werden, so dass insgesamt nach dem Erstarren der Schmelze eine Lötverbindung mit hoher mechanischer Belastbarkeit erhalten wird.

Gemäß einer ersten Ausführungsform der Erfindung ist vorgesehen, die Fügepartner im Lötbereich stoßartig zu bewegen, um den Impuls auf die Schmelzen des Lötmaterials zu übertragen. Dabei ist es insbesondere möglich, die Fügepartner im Lötbereich relativ zueinander zu bewegen.

Vorteilhafterweise werden die Fügepartner dabei für eine Zeitdauer von wenigen ms relativ zueinander bewegt. Beispielsweise können die Fügepartner weniger als 50 ms und insbesondere weniger als 10 ms relativ zueinander bewegt werden.

Gemäß einer weiteren Ausführungsform der Erfindung können die Lötmaterialschichten mit einem Laserstrahl aufgeschmolzen werden. Dabei ist es etwa bei zu verlötenden Metallblechen möglich, den Laserstrahl auf ein Metallblech zu richten, das dann die Wärme an die direkt bzw. indirekt mit dem Blech in Kontakt stehenden Lötmaterialschichten überträgt, so dass diese im Lötbereich aufschmelzen.

Es ist ebenfalls möglich, mit einem Andruckelement einen mechanischen Impuls auf die Schmelzen aus flüssigem Lötmaterial zu übertragen.

Auf die Schmelzen aus flüssigem Lötmaterial können auch mehrere kurze Impulse übertragen werden. Insbesondere können dabei Impulse mit geringer Amplitude übertragen werden.

Ein weiterer Aspekt der Erfindung betrifft eine Vorrichtung zur Durchführung des Verfahrens mit den Merkmalen des Anspruchs 1. Vorteilhafte Weiterbildungen der erfindungsgemäßen Vorrichtung sind in den Unteransprüchen angegebenen.

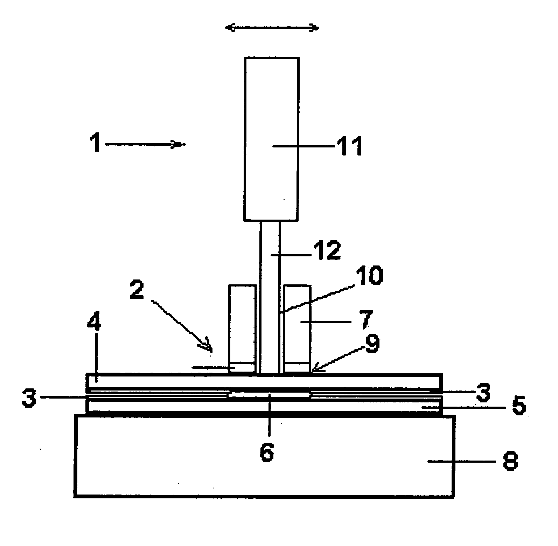

Die Erfindung wird im Folgenden anhand eines Ausführungsbeispiels unter Bezugnahme auf die Zeichnung näher erläutert. In der Zeichnung zeigt die einzige Figur eine schematische Darstellung einer Vorrichtung zum Verlöten von metallischen Fügepartnern, die jeweils mit Lötmaterial beschichtet sind.

Die Vorrichtung 1 weist eine Presseinrichtung 2 auf, um zwei jeweils mit einer Lötmaterialschicht 3 versehene Metallbleche 4, 5 in einem Lötbereich 6 gegeneinander zu pressen.

Die Presseinrichtung 2 besteht aus einem Andruckelement 7 und einem Auflageelement 8, die zwischen sich einen Pressspalt 9 ausbilden. In dem Pressspalt 9 sind die Bleche 4, 5 übereinander derart angeordnet, dass ihre jeweiligen Lötmaterialschichten 3 miteinander in Anlage kommen.

Das Andruckelement 7 ist mit in der Zeichnung nicht gezeigten Beaufschlagungsmitteln verbunden, die ausgebildet sind das Andruckelement 7 in Richtung des Pressspaltes 9 zu beaufschlagen. Weiterhin ist in dem Andruckelement 7 eine koaxial verlaufende Druchtrittsöffnung 10 ausgebildet. Mit dem Andruckelement 7 sind zusätzlich in der Zeichnung ebenfalls nicht gezeigte Impulsübertragungsmittel verbunden, die es erlauben, das Andruckelement 7 in horizontaler Richtung stoßartig zu bewegen.

Die Vorrichtung 1 weist weiterhin einen Laser 11 als Heizeinrichtung auf, der so angeordnet ist, dass er einen Laserstrahl 12 durch die Durchtrittsöffnung 10 des Andruckelements 7 auf das Metallblech 4 abgeben kann. Dabei ist der Laser 11 ebenfalls mit den Impulsübertragungsmitteln verbunden.

Um mit der Vorrichtung 1 die Bleche 4, 5 zu verlöten, werden diese mit Hilfe des Andruckelements 7 im Pressspalt zusammengepresst. Gleichzeitig wird von dem Laser 11 ein Laserstrahl 12 auf das Metallblech 4 abgegeben, wodurch sich dieses erwärmt, so dass die auf dem Blech aufgebrachte Lötmaterialschicht 3 im Lötbereich 6 schmilzt. Aufgrund des thermischen Kontakts zwischen dem Blech 4 bzw. dessen Lötmaterialschicht 3 und der Lötmaterialschicht 3 des Bleches 5 wird auch Wärme auf diese Lötmaterialschicht 3 übertragen, so dass sie ebenfalls im Lötbereich 6 geschmolzen wird.

Um die Verbindung der beiden entstandenen Schmelzen zu unterstützen und gleichzeitig eine möglichst vollständige Benetzung der beiden Metallbleche 4, 5 im Lötbereich 6 zu erzielen, wird dann auf die Schmelzen ein mechanischer Impuls übertragen. Dazu wird das Andruckelement 7 mit Hilfe des Impulsübertragungsmittels stoßartig horizontal hin und her bewegt, wie dies durch den in der Zeichnung gezeigten Pfeil angedeutet ist. Dabei überträgt sich der Bewegungsimpuls des Andruckelements 7 über das Blech 4 auf die Schmelzen aus flüssigem Lötmaterial. Es kommt zu einer intensiven Vermischung der Schmelzen und zu einer nahezu vollständigen Benetzung der Bleche 4, 5 im Lötbereich 6, woraus nach dem Erstarren der einheitlichen Schmelze eine mechanisch besonders belastbare Lötverbindung resultiert.

## Patentansprüche

1. Verfahren zum Verlöten von metallischen Fügepartnern (4, 5), die mit Lötmaterial beschichtet sind, bei dem die Lötmaterialschichten der Fügepartner (4, 5) in einem Lötbereich (6) zusammengepresst und aufgeschmolzen werden, wobei sich Schmelzen aus flüssigem Lötmaterial bilden, die nach ihrer Vermischung im erstarrten Zustand die Fügepartner (4, 5) im Lötbereich (6) verbinden, **dadurch gekennzeichnet, dass** auf die Schmelzen aus flüssigem Lötmaterial vor dem Erstarren ein mechanischer Impuls übertragen wird.

2. Verfahren nach Anspruch 1, **dadurch gekennzeichnet, dass** die Fügepartner (4, 5) im Lötbereich (6) stoßartig bewegt werden, um den Impuls auf die Schmelzen aus Lötmaterial zu übertragen.

3. Verfahren nach Anspruch 2, **dadurch gekennzeichnet, dass** die Fügepartner (4, 5) im Lötbereich (6) relativ zueinander bewegt werden.

4. Verfahren nach einem der vorhergehenden Ansprüche, **dadurch gekennzeichnet, dass** die Fügepartner (4, 5) im Lötbereich (6) stoßartig komprimiert werden, um den Impuls auf die Schmelzen aus Lötmaterial zu übertragen.

5. Verfahren nach Anspruch 4, **dadurch gekennzeichnet, dass** die Fügepartner (4, 5) für wenige ms relativ zueinander bewegt werden.

6. Verfahren nach einem der vorhergehenden Ansprüche, **dadurch gekennzeichnet, dass** die Lötmaterialschichten (3) mit einem Laserstrahl (12) aufgeschmolzen werden.

7. Verfahren nach einem der vorhergehenden Ansprüche, **dadurch gekennzeichnet, dass** mit einem Andruckelement (7) ein mechanischer Impuls auf die Schmelzen aus flüssigem Lötmaterial übertragen wird.

8. Verfahren nach einem der vorhergehenden Ansprüche, **dadurch gekennzeichnet, dass** mehrere kurze Impulse insbesondere mit geringer Amplitude auf die Schmelzen aus flüssigem Lötmaterial übertragen werden.

9. Vorrichtung (1) zum Verlöten von mit Lötmaterial (3) beschichteten metallischen Fügepartnern (4, 5), die eine Presseinrichtung (2), um die Fügepartner (4, 5) in einem Lötbereich (6) mit ihren Lötmaterialschichten gegeneinander zu pressen und eine Heizeinrichtung (11), um die Lötmaterialschichten (3) im Lötbereich (6) aufzuschmelzen, aufweist, **dadurch gekennzeichnet, dass** Impulsübertragungsmittel vorgesehen sind, um einen mechanischen Impuls in den Lötbereich (6) zu übertragen.

10. Vorrichtung (1) nach Anspruch 9, **dadurch gekennzeichnet, dass** die Impulsübertragungsmittel ausgebildet sind, die Fügepartner (4, 5) im Lötbereich (6) stoßartig zu bewegen.

11. Vorrichtung (1) nach Anspruch 10, **dadurch gekennzeichnet, dass** die Impulsübertragungsmittel ausgebildet sind, die Fügepartner (4, 5) im Lötbereich (6) relativ zueinander zu bewegen.

12. Vorrichtung (1) nach einem der Ansprüche 9 bis 11, **dadurch gekennzeichnet, dass** die Impulsübertragungsmittel ausgebildet sind, die Fügepartner (4, 5) im Lötbereich (6) stoßartig zu komprimieren.

13. Vorrichtung (1) nach einem der Ansprüche 9 bis 12, **dadurch gekennzeichnet, dass** die Heizeinrichtung (11) als Laser ausgebildet ist.

14. Vorrichtung (1) nach Anspruch 13, **dadurch gekennzeichnet, dass** die Presseinrichtung (2) ein Andruckelement (7) mit einer darin ausgebildeten Durchtrittsöffnung (10) für einen Laserstrahl (12) aufweist.

15. Vorrichtung (1) nach Anspruch 14, **dadurch gekennzeichnet, dass** das Andruckelement (7) zumindest bereichsweise als Wärmeisolator ausgebildet ist.

16. Vorrichtung (1) nach einem der Ansprüche 14 oder 15, **dadurch gekennzeichnet, dass** das Andruckelement (7) beweglich gelagert ist.

17. Vorrichtung (1) nach Anspruch 16, **dadurch gekennzeichnet, dass** das Andruckelement (7) mit dem Impulsübertragungsmitteln verbunden ist, so dass ein mechanischer Impuls über das Andruckelement (7) in den Lötbereich (6) übertragen werden kann.

18. Vorrichtung (1) nach einem der Ansprüche 9 bis 17, **dadurch gekennzeichnet, dass** die Impulsübertragungsmittel ausgebildet sind mehrere kurze Impulse insbesondere mit geringer Amplitude in den Lötbereich (6) zu übertragen.
